# EUROPÄISCHE PATENTSCHRIFT

(11) **EP 3 977 825 B1**
(45) Veröffentlichungstag und Bekanntmachung des Hinweises auf die Patenterteilung: **15.10.2025**
(21) Anmeldenummer: 20728438.1
(22) Anmeldetag: 20.05.2020
(51) Int. Cl.: H05K 3/12

(54) **VERFAHREN UND VORRICHTUNG ZUR HERSTELLUNG ELEKTRISCHER BAUTEILE AUF EINEM FLEXIBLEN TRÄGER**
METHOD AND APPARATUS FOR PRODUCING ELECTRICAL COMPONENTS ON A FLEXIBLE CARRIER
PROCÉDÉ ET APPAREIL POUR PRODUIRE DES COMPOSANTS ÉLECTRIQUES SUR UN SUPPORT FLEXIBLE

(30) Priorität: 03.06.2019 DE 102019114806
(43) Veröffentlichungstag der Anmeldung: 06.04.2022
(73) Patentinhaber: VALUE & INTELLECTUAL PROPERTIES MANAGEMENT GMBH, 83052 Bruckmühl/Heufeld (DE)
(72) Erfinder: BÄR, Kai, 83043 Bad Aibling (DE); GEITNER, Andreas, 83700 Rottach-Egern (DE); DIENZ, Michael, 41466 Neuss (DE)
(74) Vertreter: Meissner Bolte Partnerschaft mbB
(86) Internationale Anmeldenummer: PCT/EP2020/064055
(87) Internationale Veröffentlichungsnummer: WO 2020/244926

(56) Entgegenhaltungen:
- WO-A1-2011/087362
- WO-A1-2013/182896
- WO-A2-2006/071419
- DE-A1- 102017 119 280
- DE-C1- 10 048 361
- JP-A- H08 295 005
- US-A1- 2007 110 893
- US-A1- 2016 074 941

## Beschreibung

Die Erfindung betrifft ein Verfahren zur Herstellung elektrischer oder elektronischer Bauteile oder Schaltungen auf einem flexiblen flächigen oder dreidimensionalen Träger durch Aufbringen eines flüssigen oder pastösen Ausgangsmaterials für eine strukturierte oder unstrukturierte elektrische oder elektronische Funktionsschicht und anschließendes Trocknen, Sintern und/oder Vernetzen des Ausgangsmaterials auf dem Träger, sowie eine Anordnung zur Durchführung dieses Verfahrens.

Das Erzeugen von Funktionsschichten, die ein Sintern bzw. Vernetzen eines ursprünglich flüssigen oder pastösen Ausgangsmaterials einschließt, auf Komponenten elektrischer Geräte, von Energiespeichern oder in elektronischen Bauelementen oder Baugruppen gehört seit Längerem zum Stand der Technik.

Mit der dramatisch steigenden technischen und wirtschaftlichen Bedeutung moderner Batterietechnologien einerseits und der gleichermaßen schnellen Verbreitung von gedruckten elektronischen Schaltungen dieser Art (der sogenannten "printed electronics") erlangen derartige Verfahren immer größere technische und wirtschaftliche Bedeutung. Es kommt dabei zunehmend auf den Einsatz von möglichst leicht verfügbaren und kostengünstigen und zudem möglichst recyclingfähigen Trägermaterialien und andererseits auf eine an diese neuartigen Trägermaterialien angepasste Verfahrensführung mit möglichst hoher Ausbeute an hochwertigen Endprodukten an.

So werden beispielsweise bei neuartigen Batteriekonstruktionen, wie sie für die Elektromobilität und perspektivisch auch für hochleistungsfähige Speicher im Bereich der Energieerzeugung benötigt werden, neben metallischen Trägerfolien mit sehr geringer Dicke, Polymerfolien etwa auf PE-, PVC-, PET- oder PP-Basis oder auch von Papier eingesetzt. Weiterhin ist man hier bestrebt, aus Umweltschutz- und Arbeitsschutzgründen in möglichst breitem Umfang wasserlösliche Beschichtungen einzusetzen. Ähnliche Konfigurationen wurden für die Elektroden von Brennstoffzellen vorgeschlagen, wie sie künftig in Fahrzeugen mit Brennstoffzellen-Antrieb Verwendung finden könnten.

Beim Trocknen bzw. Vernetzen der Beschichtungen muss einerseits auf die Temperaturempfindlichkeit des Trägermaterials Rücksicht genommen und andererseits danach gestrebt werden, eine qualitativ einwandfreie Beschichtung (ohne trocknungsbedingte Defekte) mit möglichst hoher Durchlaufgeschwindigkeit durch eine entsprechende Trocknungsanlage zu erhalten. Es versteht sich, dass auch die Gestehungs- und Betriebskosten der Trocknungsanlagen für die Kosten der Endprodukte - die mit zunehmend massenhafter Verwendung immer niedriger werden sollen - eine erhebliche Rolle spielen. Bekannte Trocknungsanlagen vom Tunnelofen-Typ genügen diesen Anforderungen nur sehr bedingt und sind platzaufwändig und in der Gestehung und im Betrieb teuer. Derartige Systeme sind beispielsweise aus der WO2011/087362, der US2016/074941 und der DE10048361 bekannt.

Der Erfindung liegt daher die Aufgabe zu Grunde, ein verbessertes Verfahren der gattungsgemäßen Art sowie eine entsprechende Anordnung bereitzustellen, die den obigen Anforderungen gerecht werden.

Diese Aufgabe wird durch ein Verfahren mit den Merkmalen des Anspruchs 1 sowie eine Anordnung mit den Merkmalen des Anspruchs 8 gelöst. Zweckmäßige Fortbildungen des Erfindungsgedankens sind Gegenstand der jeweiligen abhängigen Ansprüche.

Die Erfindung schließt den Gedanken ein, die zum Versintern und/oder Vernetzen des Ausgangsmaterials auf dem zumindest wegen seiner Stärke, vielfach aber auch wegen des Materials wenig temperaturstabilen Träger benötigte Energie in solcher Weise bereitzustellen, dass sie ihre Wirkung im Wesentlichen im Inneren der Beschichtung entfaltet und die thermische Gesamtbelastung des Trägers (über den Zeitbereich des Trocknungsvorganges) möglichst gering bleibt. Für typische Beschichtungsmaterialien, insbesondere solche auf Wasserbasis, hat sich hierfür Strahlung im Bereich des nahen Infrarot bewährt, deren Amplitudenmaximum im Wellenlängenbereich zwischen 800 nm und 1.500 nm liegt. Diese Strahlung wird besonders effektiv in weitgehend wasserbasierten (aber auch in vielen lösemittelhaltigen) Lösungen, Emulsionen und Pasten umgesetzt.

Weiterhin gehört zur Erfindung der Gedanke, diese Strahlung mit einer solch hohen Energiedichte einwirken zu lassen, dass die angestrebte Sinterung und/oder Vernetzung in der Beschichtung in so kurzer Zeit stattfinden kann, dass die auf das Substrat übertragene Energiemenge und damit dessen thermische Gesamtbelastung begrenzt bleibt. Je nach konkretem Anwendungsfall, Träger und Beschichtung erscheinen dafür aus heutiger Sicht Energiedichten im Bereich zwischen 50 kW/m² und 1.000 kW/m², insbesondere von 120 kW/m² bei 1.000 kW/m², auf der Beschichtungsoberfläche als geeignet.

Für viele der aktuellen Anwendungen kann nach den Erkenntnissen der Erfinder die Einwirkungsdauer der nahen Infrarotstrahlung auf den Bereich zwischen 1s und 3s, insbesondere zwischen 2s und 20s, begrenzt sein. Es versteht sich, dass die konkrete Behandlungsdauer von der Dicke und Beschaffenheit der Beschichtung und von der konkret gewählten Leistungsdichte abhängt.

In aus derzeitiger Sicht besonders aussichtsreichen Anwendungen handelt es sich bei dem Träger um einen temperaturempfindlichen Träger, wie eine Polymerfolie oder Papier, und die Leistungsdichte und Einwirkungsdauer der nahen Infrarotstrahlung wird derart eingestellt, dass die Temperatur nicht über eine materialkritische Temperatur, insbesondere nicht über eine Temperatur im Beriech zwischen 100°C und 200°C, ansteigt. Der konkrete Wert der Grenztemperatur ist selbstverständlich materialabhängig, und die Einstellung der zur Einhaltung dieses Grenzwertes geeigneten Energiedichte und Durchlaufgeschwindigkeit des Trägers durch die Trocknungsanlage ist für den Fachmann mit einer begrenzten Anzahl einfacher Versuche zu ermitteln.

Das Verfahren in dieser Ausgestaltung hat Potential bei der weiteren Entwicklung der "printed electronics", als perspektivreichem Anwendungsbereich. Hierbei wird auf den Träger durch ein Druckverfahren selektiv bzw. punktuell flüssiges Aufgangsmaterial ausgetragen. Dies geschieht besonders präzise, schnell und effizient mittels eines Inkjet-Druckverfahrens. Die Leistungsdichte und Einwirkungsdauer der nahen Infrarotstrahlung wird derart eingestellt, dass in der selektiven Beschichtung kurzzeitig eine Temperatur oberhalb einer materialspezifischen Sinter- bzw. Vernetzungstemperatur, insbesondere oberhalb einer Temperatur im Bereich zwischen 50 - 200°, erreicht wird.

In einer weiteren potentiell bedeutsamen Anwendung wird ein pastöses Ausgangsmaterial im Wesentlichen ganzflächig, insbesondere durch einen Walzen- oder Rakelauftragsprozess, auf den Träger aufgetragen und ggfs. anschließend (z. B. durch Ätzprozesse oder mittels Laser) strukturiert. Die Leistungsdichte und Einwirkungsdauer der nahen Infrarotstrahlung wird auch hier derart eingestellt, dass in der selektiven Beschichtung kurzzeitig eine Temperatur oberhalb einer materialspezifischen Sinter- bzw. Vernetzungstemperatur, erreicht wird. Diese Ausgestaltung dürfte besondere Bedeutung im Bereich der Herstellung von Batterieelektroden für die Elektromobilität und die Energietechnik sowie von Brennstoffzellenelektroden erlangen.

Eine spezielle vorgeschlagene Verfahrensführung auf diesem Gebiet geht davon aus, dass als Träger eine Polymerfolie mit einer Dicke im Bereich zwischen 75µm und 200µm oder eine Metallfolie im Bereich zwischen 3µm und 10µm und als Beschichtung eine viskose Paste auf Wasserbasis oder Basis eines organischen Lösungsmittels eingesetzt wird, die eine Ausgangs-Dicke im Bereich zwischen 10 und 1.000 µm und einen Festkörperanteil im Bereich zwischen 40% und 80% hat. Hierbei ist vorgesehen, dass zum Trocknen, Sintern und/oder Vernetzen nahe Infrarotstrahlung mit einer Leistungsdichte im Bereich zwischen 50 - 200, insbesondere 70 - 150 kW/m², eingesetzt wird. Bei dieser Anwendung, die man als "Dickschichtanwendung" bezeichnen kann, ist eine präzise Steuerung der Strahlungseinwirkung in Abhängigkeit von den Parametern des Trägers und der Beschichtung und auch in zeitlicher Hinsicht bevorzugt. Eine zeitliche Steuerung ist insbesondere im Anfangs- und Endbereich eines langgestreckten flächigen Trägers von erheblicher Bedeutung für die Qualität des Endproduktes und die Ausbeute des Verfahrens.

Bei einer weiteren Anwendung, die auch als "Dünnschichtanwendung" bezeichnet werden kann und etwa bei "printed electronics" bedeutsam ist, hat die Beschichtung lediglich eine Dicke im Bereich zwischen etwa 1 und 20µm und wurde insbesondere mittels Aufdrucken oder -Spritzen ("jet technology") auf den Träger aufgebracht. Bei dieser Anwendung kann gegebenenfalls mit fest eingestellten Leistungsdichten der NIR-Strahlung gearbeitet werden, und diese können die vorstehend genannten Werte übersteigen.

In weiteren Ausgestaltungen des erfindungsgemäßen Verfahrens ist vorgesehen, dass die Beaufschlagung mit naher Infrarotstrahlung innerhalb einer NIR-Bestrahlungszone mit einem vorbestimmten Profil nicht-konstanter Leistungsdichte durchgeführt wird. Insbesondere kann hierbei das Strahlungsdichteprofil im Ansprechen auf Materialeigenschaften des Trägers und/oder des Ausgangsmaterials einstellbar sein.

Mit derartigen Verfahrensführungen lässt sich spezifischen Anforderungen bestimmter Funktionsschichten sowie auch besonders temperaturempfindlicher Träger differenziert Rechnung tragen. Insbesondere lassen sich damit Vorwärm- und Temperaturhaltephasen vor bzw. nach einer Haupt-Trocknungsphase mit hoher Leistungsdichte einstellen.

Im Übrigen lässt sich eine Temperaturhaltezone auch unabhängig von der Verwendung der nahen Infrarotstrahlung in einer nachgeschalteten Anlagenkomponente, insbesondere einem Heißlufttrockner, realisieren.

In einer weiteren, potentiell vorteilhaften Verfahrensführung wird die Beaufschlagung mit naher Infrarotstrahlung von beiden Oberflächen des Trägers her ausgeführt. Diese Verfahrensführung erscheint insbesondere bei Einsatz von relativ temperaturstabilen Trägern (etwa Metallfolien) als geeignet. Falls sie auch für Produkte mit temperaturempfindlichem Träger eingesetzt werden soll, erscheint insbesondere die Einstellung unterschiedlicher Leistungsdichten auf der Oberfläche der Beschichtung einerseits und der Oberfläche (Rückseite) des Trägers andererseits als sinnvoll.

In einer weiteren speziellen Verfahrensführung wird die Beaufschlagung mit naher Infrarotstrahlung mit der Beaufschlagung mit einem Luftstrom mindestens auf einer Oberfläche des Trägers verknüpft. Mit einem solchen Warmluftstrom lassen sich insbesondere verdunstete flüssige Bestandteile der Beschichtung leicht und in gezielter Weise (z. B. in geeignete Filter) abführen. Andererseits lässt sich eine übermäßige Erhitzung des Trägermaterials auch dann verhindern, wenn hohe Leistungsdichten für relativ lange Zeit einwirken müssen. Dies kann nötig sein, um eine relativ dicke oder materialseitig anspruchsvolle Beschichtung hinreichend zu durchwärmen.

Speziell kann vorgesehen sein, dass die Zuführung von Warmluft in der Bestrahlungszone und/oder die Zufuhr von Heißluft in einem optional vorgesehenen Heißlufttrockner jeweils auf beiden Oberflächen des Trägers vorgesehen und insbesondere einstellbar ist.

Vorrichtungsaspekte der vorliegenden Erfindung ergeben sich weitgehend aus den oben erläuterten Verfahrensaspekten. Es kann daher von einer Wiederholung der obigen Erläuterungen unter Vorrichtungs-Gesichtspunkten weitgehend Abstand genommen werden.

Nach Obigem umfasst eine erfindungsgemäße Anordnung zumindest Fördermittel zum Fördern des flexiblen flächigen Trägers durch die Anordnung, Beschichtungsmittel zum Beschichten des flächigen Trägers mit dem Ausgangsmaterial, insbesondere während des Förderns des Trägers, und Mittel zum Trocknen, Sintern und/oder Vernetzen der Ausgangsmaterialschicht auf dem Träger, insbesondere während des Förderns des Trägers, die mindestens eine Strahlungsquelle für Strahlung im Bereich des nahen Infrarot einschließen, deren Amplitudenmaximum im Wellenlängenbereich zwischen 800 nm und 1.500 nm und die derart beschaffen, konfiguriert bzw. einstellbar ist, dass ihre Leistungsdichte auf der Oberfläche des Trägers im Bereich zwischen 50 kW/m² und 1.000 kW/m² liegt.

Insbesondere schließen die Mittel zum Trocknen, Sintern und/oder Vernetzen eine Mehrzahl von NIR-Strahlungsquellen ein, die in einer NIR-Bestrahlungszone derart angeordnet und/oder steuerbar sind, dass innerhalb der Bestrahlungszone ein vorbestimmtes Profil nicht-konstanter Leistungsdichte erzeugbar ist. Dies kann insbesondere so ausgestaltet sein, dass die NIR-Strahler über die Länge der Bestrahlungszone unterschiedliche Abstände und unterschiedliche Reflektorgeometrien haben und/oder mit unterschiedlichem Abstand über der Oberfläche des beschichteten Trägers platziert sind oder es sich um Strahlungsquellen mit unterschiedlicher Leistung handelt.

Das erwähnte Profil nicht-konstanter Leistungsdichte über die Länge der Bestrahlungszone kann auch steuerbar sein, indem etwa Mittel zur Leistungssteuerung einiger oder aller NIR-Strahlungsquellen oder mechanische Einstellmittel zur variablen Einstellung der Höhe der Strahlungsquellen über dem Träger vorgesehen sind. Auf diese Weise kann insbesondere die Bestrahlungszone flexibel in einen Vorwärmbereich und einen Haupt-Trocknungsbereich und/oder einen Haupt-Trocknungsbereich und einen Temperaturhaltebereich konfiguriert werden.

Zur Realisierung der erwähnten Behandlungstemperatur-Haltezone kann auch ein separater Behandlungsabschnitt in der Trocknungsanordnung vorgesehen sein, der insbesondere als Heißlufttrockner bzw. als Tunnelofenabschnitt konstruiert ist.

Des Weiteren können der NIR-Bestrahlungszone Mittel zur Zuführung eines Luftstroms, also insbesondere ein oder mehrere Gebläse mit zugehörigen Luftleiteinrichtungen, zugeordnet sein. In einer weiteren Ausgestaltung können diese so konfiguriert sein, dass der Luftstrom, nachdem er die Oberfläche der Beschichtung überstrichen hat, in eine Filtereinrichtung zur Ausfilterung schädlicher Lösemittelkomponenten der Beschichtung und/oder in einen Wärmetauscher zur Energierückgewinnung gelangt. Eine entsprechende Filter- oder Wärmetauschereinrichtung ist dann gleichfalls Bestandteil der vorgeschlagenen Anordnung.

Weiterhin kann vorgesehen sein, dass die Mittel zur Zuführung eines Luftstroms und/oder die Behandlungstemperatur-Haltezone Steuermittel zur Steuerung des Luftstromes bzw. der Temperatur in der Behandlungstemperatur-Haltezone aufweisen. Dies ermöglicht eine Steuerung des Trocknungsprozesses in besonders flexibel an verschiedenartige Träger und Beschichtungen anpassbarer Weise und somit die Verarbeitung unterschiedlicher Träger-Beschichtungs-Konfigurationen für elektrische oder elektronische Anwendungen in ein- und derselben Trocknungsanordnung ohne aufwändige konstruktive Umgestaltungen.

Vorteile und Zweckmäßigkeiten der Erfindung ergeben sich im Übrigen aus der nachfolgenden Beschreibung von Ausführungsbeispielen und Aspekten, teilweise anhand von Figuren. Es zeigen:
- Fig. 1: eine schematische Darstellung einer Ausführungsform der erfindungsgemäßen Anordnung in Art eines Längsschnittes,
- Fig. 2: eine schematische Darstellung einer Ausführungsform des NIR-Trockners 1A nach Fig. 1, und
- Fig. 3: eine schematische Darstellung einer weiteren Ausführung des NIR-Trockners einer erfindungsgemäßen Anordnung, zusammen mit weiteren Anlagenkomponenten.

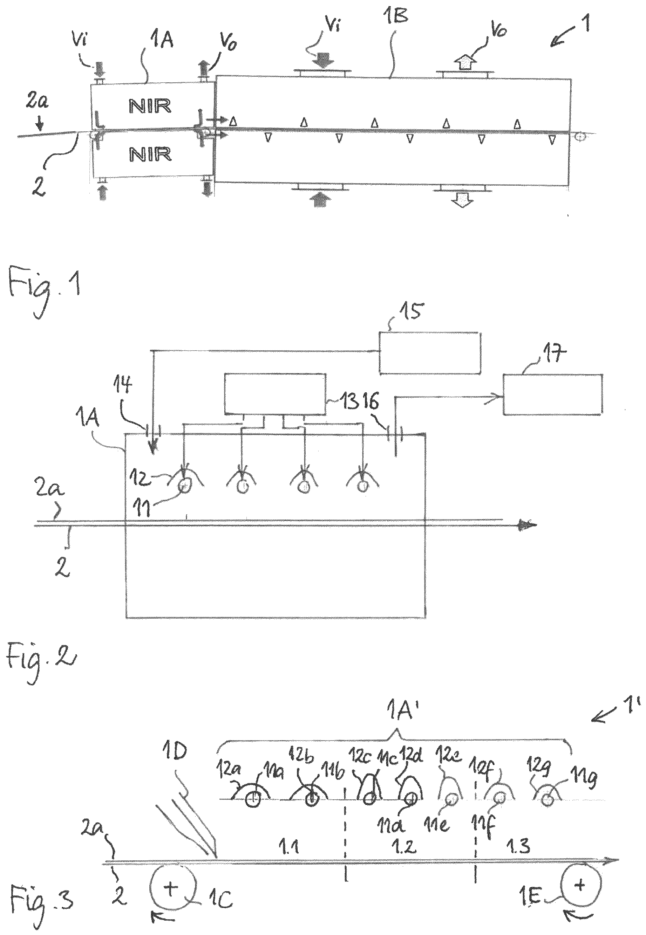

Fig. 1 zeigt das Konzept einer Trocknungsanlage 1 für funktional beschichtete Träger 2, die im fertigen Zustand als Batterie- oder Brennstoffzellenelektrode dienen sollen. Bei dem Träger kann es sich um eine quasi-endlose Al- oder Cu-Folie handeln, die in einem (hier nicht gezeigten) Beschichter mittels eines Rakelsystems oder einer Breitschlitzdüse mit einer viskosen Paste 2a auf Wasserbasis oder Basis eines organischen Lösungsmittels mit einem typischen Festkörperanteil zwischen 50% und 70% beschichtet wurde.

Die Dicke der Trägerfolie kann im Bereich zwischen 5 und 150µm und die Nass-Schichtdicke der viskosen Paste im Bereich zwischen 10 und 1.000µm liegen. In der dargestellten Ausführung ist die Beschichtung einseitig auf die Oberseite des Trägers aufgebracht, es können jedoch in aufeinanderfolgenden Beschichtungs- und Trocknungsphasen auch beidseitig beschichtete Batteriekomponenten hergestellt werden. Anstelle von Metallfolien können auch Polymerfolien (z. B. PET-Folien) mit deutlich größerer Dicke (z. B. zwischen 100 und 150µm) als Träger Einsatz finden.

Zur Trocknung der genannten Träger umfasst die Trocknungsanlage 1 einen NIR-Trockner 1A mit beidseits des Trägers 2 vorgesehenen (hier nicht gezeigten) NIR-Strahlern und integrierter Warmluftventilation, die durch die Pfeile Vi und Vo symbolisiert ist. Der NIR-Trockner 1A hat ein variabel einstellbares Temperaturprofil, welches durch entsprechende Leistungssteller der NIR-Trockner realisiert wird, und auch der Warmluftstrom ist einstellbar. In Förderrichtung des Trägers 2 stromabwärts des NIR-Trockners 1A schließt sich an diesen direkt ein Heißlufttrockner 1B an, der ebenfalls eine Warmluftventilation Vi/Vo mit variabel einstellbarer Luftmenge aufweist.

Bei einer Gesamt-Anlagenlänge von einigen Metern, die aus Platzgründen als vorteilhaft angesehen wird, und mit einem NIR-Trockner, der mit handelsüblichen NIR-Strahlern mit zugeordnetem Reflektor bestückt ist, lassen sich unter Beachtung der Qualitätsanforderungen an den Trocknungsprozess Durchlaufgeschwindigkeiten im Bereich von 1 - 2 m/min und somit ein Trocknungsprozess realisieren, der hinsichtlich Platzbedarf und Durchsatz gegenüber bekannten Trocknungsanlagen deutliche Vorteile bietet.

Fig. 2 zeigt beispielhaft in Art eines Funktions-Blockschaltbildes wesentliche Komponenten eines beispielhaften NIR-Trockners 1A gemäß Fig. 1. Die Figur ist als Prinzipskizze zu verstehen und soll nicht den tatsächlichen mechanischen Aufbau des NIR-Trockners zeigen. Zur Vereinfachung sind lediglich die Funktionskomponenten oberhalb des Trägers 2 dargestellt. Entsprechende Komponenten können auch unterhalb des Trägers vorgesehen sein; es sind aber auch Ausführungen der erfindungsgemäßen Anordnung möglich, bei denen entsprechende Mittel ausschließlich auf einer (der beschichteten) Seite des Trägers vorgesehen sind.

Der NIR-Trockner 1A umfasst mehrere NIR-Strahler 11 mit jeweils zugeordnetem Reflektor 12, die einzeln mit jeweils einem Steuerausgang einer Leistungssteuereinheit 13 verbunden sind. Über die Leistungssteuereinheit 13 kann somit die Bestrahlungsleistung jedes einzelnen NIR-Strahlers 11 separat eingestellt und somit ein vorbestimmtes Leistungsdichteprofil der NIR-Strahlung auf dem Träger 2 über die Länge des NIR-Trockners 1 realisiert werden.

Über eine Luftzuführung 14 gelangt eine über eine Luftmengensteuereinheit 15 steuerbare Menge an Luft in den Eingang von NIR-Trockner 1A, und über einen Abluftausgang 16 gelangt die erwärmte Abluft, die Lösemittelbestandteile der Beschichtung 2a aufgenommen hat, zu einer Wärmetauscher- und Filtereinheit 17. In der Wärmetauscher- und Filtereinheit 17 wird der Abluft des NIR-Trockners überschüssige Wärme entzogen und zur externen Verwendung bereitgestellt, und es werden die Lösemittelbestandteile umweltschonend ausgefiltert und ggfs. rezykliert.

Fig. 3 zeigt ein Beispiel einer Anordnung 1' zur Durchführung des erfindungsgemäßen Verfahrens, in der schematisch zwei Transportwalzen 1C, 1E als Fördermittel zum Fördern des Trägers 2 durch die Anordnung und eine Rakeleinrichtung 1D als Beschichtungeinrichtung dargestellt sind. Zum Sintern/ Vernetzen der auf den Träger 2 aufgetragenen Beschichtung 2a wird eine NIR-Bestrahlungszone 1A' durch eine Mehrzahl von NIR-Strahlern 11a - 11g mit jeweils angebautem Reflektor 12a - 12g realisiert.

Es wird darauf hingewiesen, dass die Anzahl und Ausführung der NIR-Strahler hier lediglich als Konzept-Darstellung zu verstehen ist. Durch einen Satz von Strahlern mit verschiedener Reflektorgeometrie in unterschiedlichem Abstand werden innerhalb der NIR-Bestrahlungszone 1A' eine Vorwärmzone 1.1, eine Haupt-Trockenzone 1.2 und eine Temperaturhaltezone 1.3 realisiert. Dies stellt eine Alternative zur weiter oben in Verbindung mit Fig. 2 erläuterten individuellen Leistungseinstellung von grundsätzlich baugleichen NIR-Strahlern dar.

Als NIR-Strahler kommen in einer erfindungsgemäßen Anordnung vor allem seit Langem bei Trocknungsaufgaben bewährte und kostengünstige stabförmige Halogenstrahler in Betracht. Grundsätzlich kann eine NIR-Bestrahlungszone aber auch durch anders geformte Strahler oder durch ein LED-Array mit entsprechend leistungsstarken IR-LEDs realisiert werden. Beide Ausführungen sind dem Fachmann vertraut und bedürfen daher hier keiner weiteren Erläuterung.

Als Reflektoren kommen sowohl einzelne Reflektoren, die jeweils mit einem Strahler baulich vereinigt sind, als auch integrierte Reflektoranordnungen in Betracht, die mehreren Strahlern zugeordnet sind. Auch in solchen zusammenhängenden Reflektorbaugruppen sind unterschiedliche Reflektorgeometrien für die jeweiligen Strahler (wie in Fig. 3 skizzenartig dargestellt) realisierbar.

Anordnungen der in den Figuren gezeigten Art, ggfs. anwendungsspezifisch modifiziert, sind auch zur Herstellung von Produkten aus dem Bereich der "printed electronics" einsetzbar. Dort handelt es sich bei den Trägern beispielsweise um Papier- oder Kunststofffolien, die je nach Materialspezifik nicht über Grenztemperaturen in einem Bereich zwischen etwa 80°C und 140°C erhitzt werden dürfen, und bei den Beschichtungen kann es sich - je nach Funktion der entsprechenden Komponente - um leitfähige Tinten, Pasten oder auch Pulver handeln. Die thermische Behandlung zielt demnach auf eine Verdunstung von Wasser bzw. Lösungsmitteln, ein Sintern der Paste, ein Aufschmelzen und ggfs. Sintern eines Pulvers und ggfs. auch auf die Herbeiführung thermochemischer Reaktionen und von Phasentransformationen in der Beschichtung ab.

Auch bei diesen Prozessen bietet nach den Untersuchungen der Erfinder die Nutzung einer NIR-Bestrahlungszone eine wesentliche Beschleunigung und somit die Möglichkeit einer gravierenden Erhöhung des Durchsatzes und/oder Reduzierung der Baulänge eines entsprechenden Trockners.

Die Ausführung ist nicht auf die oben erläuterten Beispiele und hervorgehobenen Aspekte beschränkt, sondern ebenso in einer Vielzahl von Abwandlungen möglich, die im Rahmen des Bereichs der anhängenden Ansprüche liegen.

## Patentansprüche

1. Verfahren zur Herstellung elektrischer oder elektronischer Bauteile oder Schaltungen auf einem flexiblen flächigen oder dreidimensionalen Träger durch Aufbringen eines flüssigen oder pastösen Ausgangsmaterials für eine strukturierte oder unstrukturierte elektrische oder elektronische Funktionsschicht und anschließendes Trocknen, Sintern und/oder Vernetzen des Ausgangsmaterials auf dem Träger,
wobei der Schritt des Trocknens, Sinterns und/oder Vernetzens eine oberflächliche Beaufschlagung des beschichteten Trägers mit Strahlung von Halogenstrahlern oder IR-LEDs im Bereich des nahen Infrarot einschließt, deren Amplitudenmaximum im Wellenlängenbereich zwischen 800 nm und 1.500 nm liegt, ausgestaltet als Verfahren zur Herstellung einer Batterie- oder Brennstoffzellenelektrode, wobei als Träger eine Polymerfolie mit einer Dicke im Bereich zwischen 75µm und 200µm oder eine Metallfolie mit einer Dicke im Bereich zwischen 3µm und 10µm und als Beschichtung eine viskose Paste auf Wasserbasis oder Basis eines organischen Lösungsmittels eingesetzt wird, die eine Ausgangs-Dicke im Bereich zwischen 10 und 1.000µm und einen Festkörperanteil im Bereich zwischen 40% und 80% hat und wobei zum Trocknen, Sintern und/oder Vernetzen nahe Infrarotstrahlung mit einer Leistungsdichte im Bereich zwischen 50 und 200 kW/m², insbesondere zwischen 70 und 150 kW/m² mit einer Einwirkungsdauer im Bereich zwischen 1s und 30s, insbesondere zwischen 2s und 20s, eingesetzt wird.

2. Verfahren nach Anspruch 1, wobei es sich bei dem Träger um einen temperaturempfindlichen Träger, nämlich eine Polymerfolie, handelt und die Leistungsdichte und Einwirkungsdauer der nahen Infrarotstrahlung derart eingestellt wird, dass die Temperatur nicht über eine materialkritische Temperatur, insbesondere nicht über eine materialkritische Temperatur im Beriech zwischen 100°C und 200°C ansteigt.

3. Verfahren nach Anspruch 1, wobei ein pastöses Ausgangsmaterial im Wesentlichen ganzflächig, insbesondere durch einen Walzen- oder Rakelauftragsprozess, auf den Träger aufgetragen wird und die Leistungsdichte und Einwirkungsdauer der nahen Infrarotstrahlung derart eingestellt wird, dass in der selektiven Beschichtung eine Temperatur oberhalb einer materialspezifischen Sinter- bzw. Vernetzungstemperatur erreicht wird.

4. Verfahren nach einem der vorangehenden Ansprüche, wobei die Beaufschlagung mit naher Infrarotstrahlung innerhalb einer NIR-Bestrahlungszone mit einem vorbestimmten Profil nicht-konstanter Leistungsdichte durchgeführt wird und insbesondere das Strahlungsdichteprofil in der Bestrahlungszone im Ansprechen auf Materialeigenschaften des Trägers und/oder des Ausgangsmaterials einstellbar ist.

5. Verfahren nach einem der vorangehenden Ansprüche, wobei die Beaufschlagung mit naher Infrarotstrahlung mit der Beaufschlagung mit einem Luftstrom mindestens auf einer Oberfläche des Trägers verknüpft wird.

6. Verfahren nach Anspruch 5, wobei die Zuführung von Warmluft in der Bestrahlungszone und/oder die Zufuhr von Heißluft in einem optional vorgesehenen Heißlufttrockner jeweils auf beiden Oberflächen des Trägers vorgesehen und insbesondere einstellbar ist.

7. Verfahren nach einem der vorangehenden Ansprüche, wobei nachfolgend auf die Beaufschlagung mit naher Infrarotstrahlung der beschichtete Träger durch eine Behandlungstemperatur-Haltezone, insbesondere einen Heißlufttrockner, geführt wird.

8. Anordnung zur Durchführung des Verfahrens nach einem der vorangehenden Ansprüche, umfassend
- Fördermittel zum Fördern des flexiblen flächigen Trägers durch die Anordnung,
- Beschichtungsmittel zum Beschichten des flächigen Trägers mit dem Ausgangsmaterial, insbesondere während des Förderns des Trägers, und
- Mittel zum Trocknen, Sintern und/oder Vernetzen der Ausgangsmaterialschicht auf dem Träger, insbesondere während des Förderns des Trägers, die mindestens einen Halogenstrahler oder eine IR-LED für Strahlung im Bereich des nahen Infrarot einschließen, deren Amplitudenmaximum im Wellenlängenbereich zwischen 800 nm und 1.500 nm liegt und die derart einstellbar sind, dass ihre Leistungsdichte auf der Oberfläche des Trägers im Bereich zwischen 50 und 200 kW/m² liegt, wobei die Fördermittel und Beschichtungsmittel daran angepasst sind, dass als Träger eine Polymerfolie mit einer Dicke im Bereich zwischen 75µm und 200µm oder eine Metallfolie mit einer Dicke im Bereich zwischen 3µm und 10µm und als Beschichtung eine viskose Paste auf Wasserbasis oder Basis eines organischen Lösungsmittels eingesetzt wird, die eine Ausgangs-Dicke im Bereich zwischen 10 und 1.000µm und einen Festkörperanteil im Bereich zwischen 40% und 80% hat.

9. Anordnung nach Anspruch 8, wobei die Mittel zum Trocknen, Sintern und/oder Vernetzen eine Mehrzahl von NIR-Strahlungsquellen einschließen, die in einer NIR-Bestrahlungszone derart angeordnet und/oder steuerbar sind, dass innerhalb der Bestrahlungszone auf der Oberfläche der Ausgangsmaterialschicht ein vorbestimmtes Profil nicht-konstanter Leistungsdichte erzeugbar ist.

10. Anordnung nach Anspruch 8 oder 9, wobei die Mittel zum Trocknen, Sintern und/oder Vernetzen weiterhin eine Behandlungstemperatur-Haltezone aufweisen, die insbesondere als Heißlufttrockner ausgeführt ist.

11. Anordnung nach Anspruch 9 oder 10, wobei der NIR-Bestrahlungszone Mittel zur Zuführung eines Luftstroms zugeordnet sind.

12. Anordnung nach Anspruch 11, wobei die Mittel zur Zuführung eines Luftstroms und/oder die Behandlungstemperatur-Haltezone Steuermittel zur Steuerung des Luftstromes bzw. der Temperatur in der Behandlungstemperatur-Haltezone aufweisen.

## Claims

1. Method for producing electrical or electronic components or circuits on a flexible flat or three-dimensional carrier by applying a liquid or pasty starting material for a structured or unstructured electrical or electronic functional layer and then drying, sintering, and/or cross-linking the starting material on the carrier,
wherein the step of drying, sintering and/or cross-linking includes exposing the coated substrate to radiation from halogen emitters or IR LEDs in the near-infrared range, the maximum amplitude of which lies in the wavelength range between 800 nm and 1,500 nm, designed as a method for manufacturing a battery or fuel cell electrode, wherein a polymer film with a thickness in the range between 75µm and 200µm or a metal film with a thickness in the range between 3µm and 10µm is used as the substrate and a viscous paste based on water or an organic solvent is used as the coating, which has an initial thickness in the range between 10 and 1,000µm and a solid content in the range between 40% and 80%, and wherein near-infrared radiation with a power density in the range between 50 and 200 kW/m², in particular between 70 and 150 kW/m² with an exposure time in the range between 1 s and 30 s, in particular between 2 s and 20 s, is used for drying, sintering and/or crosslinking.

2. Method according to claim 1, wherein the carrier is a temperature-sensitive carrier, namely a polymer film, and the power density and exposure time of the near-infrared radiation are adjusted such that the temperature does not rise above a material-critical temperature, in particular not above a material-critical temperature in the range between 100°C and 200°C.

3. Method according to claim 1, wherein a pasty starting material is applied to the carrier essentially over the entire surface, in particular by a roller or squeegee application process, and the power density and exposure time of the near-infrared radiation are adjusted such that a temperature above a material-specific sintering or cross-linking temperature is reached in the selective coating.

4. Method according to one of the preceding claims, wherein the exposure to near-infrared radiation is carried out within a NIR irradiation zone with a predetermined profile of non-constant power density and, in particular, the radiation density profile in the irradiation zone is adjustable in response to material properties of the substrate and/or the starting material.

5. Method according to one of the preceding claims, wherein the exposure to near-infrared radiation is combined with exposure to an air flow at least on one surface of the carrier.

6. Method according to claim 5, wherein the supply of warm air in the irradiation zone and/or the supply of hot air in an optionally provided hot air dryer is provided on both surfaces of the carrier and, in particular, is adjustable.

7. Method according to one of the preceding claims, wherein, following the exposure to near-infrared radiation, the coated carrier is passed through a treatment temperature holding zone, in particular a hot air dryer.

8. Arrangement for carrying out the method according to one of the preceding claims, comprising
- conveying means for conveying the flexible flat carrier through the arrangement,
- coating means for coating the flat carrier with the starting material, in particular during the conveying of the carrier, and
- means for drying, sintering, and/or cross-linking the starting material layer on the carrier, in particular during the transport of the carrier, which include at least one halogen radiator or an IR LED for radiation in the near-infrared range, whose maximum amplitude lies in the wavelength range between 800 nm and 1,500 nm and which are adjustable in such a way that their power density on the surface of the carrier lies in the range between 50 and 200 kW/m² whereby the conveying means and coating means are adapted ly such that a polymer film with a thickness in the range between 75µm and 200µm or a metal film with a thickness in the range between 3µm and 10µm is used as the carrier and a viscous paste based on water or an organic solvent is used as the coating, which has an initialthickness in the range between 10 and 1,000µm and a solid content in the range between 40% and 80%.

9. Arrangement according to claim 8, wherein the means for drying, sintering and/or crosslinking include a plurality of NIR radiation sources which are arranged and/or controllable in a NIR irradiation zone in such a way that a predetermined profile of non-constant power density can be generated within the irradiation zone on the surface of the starting material layer.

10. Arrangement according to claim 8 or 9, wherein the means for drying, sintering and/or cross-linking further comprise a treatment temperature holding zone, which is designed in particular as a hot-air dryer.

11. Arrangement according to claim 9 or 10, wherein the NIR irradiation zone is assigned means for supplying an air flow.

12. Arrangement according to claim 11, wherein the means for supplying an air flow and/or the treatment temperature holding zone comprise control means for controlling the air flow or the temperature in the treatment temperature holding zone.

## Revendications

1. Procédé de fabrication de composants ou de circuits électriques ou électroniques sur un support flexible plat ou tridimensionnel par application d'un matériau de départ liquide ou pâteux pour une couche fonctionnelle électrique ou électronique structurée ou non structurée, puis séchage, frittage et/ou réticulation du matériau de départ sur le support,
l'étape de séchage, de frittage et/ou de réticulation comprenant une exposition superficielle du support revêtu à un rayonnement provenant d'émetteurs halogènes ou de LED IR dans la gamme du proche infrarouge, dont l'amplitude maximale se situe dans la gamme de longueurs d'onde comprise entre 800 nm et 1 500 nm, conçu comme procédé de fabrication d'une électrode de batterie ou de pile à combustible, dans lequel on utilise comme support une feuille de polymère d'une épaisseur comprise entre 75µm et 200µm ou une feuille métallique d'une épaisseur comprise entre 3µm et 10µm et comme revêtement une pâte visqueuse à base d'eau ou à base d'un solvant organique, qui a une épaisseur initialecomprise entre 10 et 1 000µm et une teneur en matière solide comprise entre 40 % et 80 %, et dans lequel, pour le séchage, le frittage et/ou la réticulation, on utilise un rayonnement infrarouge proche ayant une densité de puissance comprise entre 50 et 200 kW/m², en particulier entre 70 et 150 kW/m² avec une durée d'exposition comprise entre 1 s et 30 s, en particulier entre 2 s et 20 s, est utilisé.

2. Procédé selon la revendication 1, dans lequel le support est un support sensible à la température, à savoir une feuille polymère, et la densité de puissance et la durée d'exposition du rayonnement infrarouge proche sont réglées de telle sorte que la température ne dépasse pas une température critique pour le matériau, en particulier une température critique pour le matériau comprise entre 100 °C et 200 °C.

3. Procédé selon la revendication 1, dans lequel une matière première pâteuse est appliquée sur pratiquement toute la surface du support, en particulier par un procédé d'application au rouleau ou à la raclette, et la densité de puissance et la durée d'exposition du rayonnement infrarouge proche sont réglées de telle sorte qu'une température supérieure à une température de frittage ou de réticulation spécifique au matériau est atteinte dans le revêtement sélectif.

4. Procédé selon l'une des revendications précédentes, dans lequel l'exposition au rayonnement infrarouge proche est réalisée dans une zone d'irradiation NIR avec un profil prédéterminé de densité de puissance non constante et, en particulier, le profil de densité de rayonnement dans la zone d'irradiation est réglable en fonction des propriétés du matériau du support et/ou du matériau de départ.

5. Procédé selon l'une des revendications précédentes, dans lequel l'exposition au rayonnement infrarouge proche est associée à l'exposition à un flux d'air au moins sur une surface du support.

6. Procédé selon la revendication 5, dans lequel l'alimentation en air chaud dans la zone d'irradiation et/ou l'alimentation en air chaud dans un séchoir à air chaud prévu en option est prévue sur les deux surfaces du support et est notamment réglable.

7. Procédé selon l'une des revendications précédentes, dans lequel, après l'exposition au rayonnement infrarouge proche, le support revêtu est guidé à travers une zone de maintien à température de traitement, en particulier un séchoir à air chaud.

8. Dispositif pour la mise en œuvre du procédé selon l'une des revendications précédentes, comprenant
- des moyens de transport pour transporter le support plat flexible à travers le dispositif,
- des moyens de revêtement pour revêtir le support plat avec le matériau de départ, en particulier pendant le transport du support, et
- des moyens pour sécher, fritter et/ou réticuler la couche de matériau de départ sur le support, en particulier pendant le transport du support, qui comprennent au moins un émetteur de rayonnement halogène ou une LED IR pour un rayonnement dans la gamme du proche infrarouge, dont l'amplitude maximale se situe dans la gamme de longueurs d'onde comprise entre 800 nm et 1 500 nm et qui sont réglables de telle sorte que leur densité de puissance à la surface du support se situe dans la gamme comprise entre 50 et 200 kW/m², les moyens de transport et les moyens de revêtement étant adaptés de maniè e à l'utilisation, comme support, d'un film polymère d'une épaisseur comprise entre 75µm et 200µm ou d'un film métallique d'une épaisseur comprise entre 3µm et 10µm et, comme revêtement, d'une pâte visqueuse à base d'eau ou d'un solvant organique, qui a une épaisseur initialecomprise entre 10 et 1 000µm et une teneur en matière solide comprise entre 40 % et 80 %.

9. Dispositif selon la revendication 8, dans lequel les moyens de séchage, de frittage et/ou de réticulation comprennent une pluralité de sources de rayonnement NIR qui sont disposées et/ou commandées dans une zone d'irradiation NIR de telle sorte qu'un profil prédéterminé de densité de puissance non constante peut être généré à l'intérieur de la zone d'irradiation sur la surface de la couche de matériau de départ.

10. Dispositif selon la revendication 8 ou 9, dans lequel les moyens de séchage, de frittage et/ou de réticulation comprennent en outre une zone de maintien de la température de traitement, qui est notamment réalisée sous la forme d'un séchoir à air chaud.

11. Dispositif selon la revendication 9 ou 10, dans lequel la zone d'irradiation NIR est associée à des moyens pour fournir un flux d'air.

12. Dispositif selon la revendication 11, dans lequel les moyens pour amener un flux d'air et/ou la zone de maintien de la température de traitement comportent des moyens de commande pour commander le flux d'air ou la température dans la zone de maintien de la température de traitement.
